# EUROPEAN PATENT SPECIFICATION

(11) **EP 3 015 219 B1**
(45) Date of publication and mention of the grant of the patent: **18.09.2019**
(21) Application number: 15192299.4
(22) Date of filing: 30.10.2015
(51) Int. Cl.: B23Q 7/14, B23Q 16/06, H05K 13/00

(54) **AUTOMATIC COMPONENT LOADING SYSTEM**
AUTOMATISCHES BAUTEILLADESYSTEM
SYSTÈME DE CHARGEMENT AUTOMATIQUE DE COMPOSANT

(30) Priority: 31.10.2014 CN 201410607066
(43) Date of publication of application: 04.05.2016
(73) Proprietor: Tyco Electronics (Shanghai) Co. Ltd., Shanghai Guangdong (CN); Tyco Electronics (Shenzhen) Co. Ltd., Baoan District Shenzhen Guangdong 518008 (CN); Shenzhen AMI Technology Co., Ltd, Shenzhen Guangdong (CN)
(72) Inventor: DENG, Yingcong, Shanghai (CN); ZHANG, Dandan, Shanghai (CN); LU, Roberto Francisco-Yi, Shanghai (CN); WU, Yaodong, Shanghai (CN); CHEN, Zhenliang, Shanghai (CN); LI, Zhao, Shanghai (CN); SU, Jin, Shanghai (CN); LI, Zhi, Shanghai (CN); ZENG, Qinglong, Shanghai (CN)
(74) Representative: Grünecker Patent- und Rechtsanwälte PartG mbB

(56) References cited:
- CN-U- 201 853 730
- GB-A- 1 234 268

## Description

### BACKGROUND OF THE INVENTION

### Field of the Invention

Embodiments of the present invention relate to an automatic component loading system, more particularly, relates to an automatic component loading system capable of transmitting a tray, on which components are loaded, to a predetermined position.

### Description of the Related Art

Generally, an electrical equipment, such as, electrical connector, fiber optic connector, relay, etc., comprises many components, for example, housing, contact, spring, bolt, insulation member or the like. During producing such electrical equipment, a set of components with different shapes and functions are required to be prepared in advance and loaded on a first tray. Then, a loading device picks up the respective components from the first tray based on a preset program and places the picked components on a second tray located on a conveying device. Then, the conveying device transmits the second tray to a predetermined position. Such a system is known from patent document CN201853730U. Then, a robot selects these components from the second tray and assemblies these components into the electrical equipment on an operation stage based on a preset program.

In general, the robot selects the required components from the second tray located at a fixed position. Thereby, the position accuracy of the second tray will affect the efficiency of the robot to obtain the respective components.

### SUMMARY OF THE INVENTION

The present invention has been made to overcome or alleviate at least one aspect of the above mentioned disadvantages.

According to an object of the present invention, there is provided an automatic component loading system, in which a position correcting device is provided to ensure that a tray on which components to be loaded is accurately and efficiently positioned at its loading position.

According to an aspect of the present invention, there is provided an automatic component loading system, comprising: a loading device configured to pick up respective components based on a preset program; a conveying device provided with a plurality of first trays for receiving the components thereon and configured so that the plurality of first trays each is circularly moved between a loading position and an unloading position to allow the loading device to load the picked components on the first tray at the loading position; and a position correcting device configured to drive the conveying device or each first tray to move in a case where the first tray deviates from its loading position, so as to position the first trays at the respective loading positions thereof..

In an exemplary embodiment of the present invention, the conveying device comprises a turntable constructed to rotate in a horizontal plane, the plurality of first trays being arranged on peripheral edge of the turntable by a regular interval.

In the above exemplary embodiment of the present invention, the position correcting device comprises: a plurality of first correcting mechanisms mounted on a lower portion of the turntable and corresponding to the loading positions of the respective first trays; and a second correcting mechanism fixedly provided relative to the turntable, wherein the second correcting mechanism is configured to drive the turntable or the first trays to move, by cooperating with each first correction mechanisms, in the case where each first tray deviates from its loading position, so as to position the first trays at the respective loading positions thereof.

In the above exemplary embodiment of the present invention, each first correcting mechanism comprises at least one slot extending upwardly from a bottom surface of the turntable. The second correcting mechanism comprises: at least one pin each configured to be mated with the respective slot, at least one of the pin and the slot mated with each other having a sloped contact surface; and a driving device configured to drive the at least one pin into the respective slot, so as to drive the turntable to move by means of the contact surface in the case where each first tray deviates from its loading position.

In another exemplary embodiment of the present invention, the slot and the pin both substantially exhibit a cone shape.

In another exemplary embodiment of the present invention, the slot substantially exhibits a cylindrical shape, and the pin substantially exhibits a cone shape.

In another exemplary embodiment of the present invention, the first correcting mechanisms each comprises: at least one first slot passing through the turntable; and at least one second slot extending upwardly from a bottom surface of the first tray and corresponding to the respective first slot. The second correcting mechanism comprises: at least one pin each configured to be mated with the respective slot, at least one of the pin and the slot mated with each other having a sloped contact surface; and a driving device configured to drive the at least one pin into the respective slot, so as to drive the first tray to move by means of the contact surface in the case where each first tray deviates from its loading position.

In another exemplary embodiment of the present invention, the first slot substantially exhibits a cylindrical shape or a truncated cone shape, and the second slot substantially exhibits a cylindrical shape. The pin comprises: a cylindrical portion mated with the second slot; and a truncated cone portion located at one end of the cylindrical portion and mated with the first slot, the contact surface being formed on the truncated cone portion.

In another exemplary embodiment of the present invention, the position correcting device drives the turntable to rotate, so as to move the first tray within a range less than 0.01mm.

In another exemplary embodiment of the present invention, the second correcting mechanism is fixed on the loading device.

In another exemplary embodiment of the present invention, the position correcting device comprises a position sensor configured to detect a deviation of the first tray from its loading position.

In another exemplary embodiment of the present invention, the conveying device further comprises: a first base; and a motor mounted on the first base and configured to drive the turntable to rotate.

In another exemplary embodiment of the present invention, the loading device comprises: a second base; a second tray, on which the components are pre-placed, mounted on the second base; a rail mounted on the second base; and a picking device movably mounted on the rail and configured to pick up the components from the second tray and place the picked components on the respective first trays.

In another exemplary embodiment of the present invention, the loading device further comprises a storage device for storing the components.

In another exemplary embodiment of the present invention, the automatic component loading system further comprises a first robot configured to transfer the components from the storage device to the second tray.

In another exemplary embodiment of the present invention, the automatic component loading system further comprises a second robot configured to pick up the respective components from the first tray at the unloading position based on a preset program.

In the above various exemplary embodiments of the present invention, the position correcting device is configured to drive the conveying device to move in a case where each first tray deviates from its loading position, so as to accurately position the first tray and/or a turntable at the loading position thereof. In this way, it may ensure that the first tray on which components to be loaded is accurately and efficiently positioned at its loading position, and the components may be accurately loaded on respective locations of the first tray, facilitating a subsequent operation of automatically gripping the components.

### BRIEF DESCRIPTION OF THE DRAWINGS

The above and other features of the present invention will become more apparent by describing in detail exemplary embodiments thereof with reference to the accompanying drawings, in which:
Fig.1 is an illustrative perspective view of an automatic component loading system according to an exemplary embodiment of the present invention;
Fig.2 is a side view of the automatic component loading system of Fig.1;
Fig.3 is an illustrative perspective view of a conveying device and a position correcting device according to an exemplary embodiment of the present invention;
Fig.4 is an illustrative perspective view of a loading device according to an exemplary embodiment of the present invention;
Fig.5 is an illustrative perspective view of a robot according to an exemplary embodiment of the present invention;
Fig.6 is an illustrative principle view showing a first tray deviating from its ideal loading position;
Fig.7 is an illustrative principle view of positioning the first tray at the ideal loading position by a position correcting device according to a first exemplary embodiment;
Fig.8 is an illustrative principle view showing a turntable deviating from its ideal loading position;
Fig.9 is an illustrative principle view of positioning the turntable at the ideal loading position by a position correcting device according to a second exemplary embodiment; and
Fig.10 is an illustrative principle view of positioning the turntable at the ideal loading position by a position correcting device according to a third exemplary embodiment.

### DETAILED DESCRIPTION OF PREFERRED EMBODIMENTS OF THE

### IVENTION

Exemplary embodiments of the present disclosure will be described hereinafter in detail with reference to the attached drawings, wherein the like reference numerals refer to the like elements.

According to a general concept of the present invention, there is provided an automatic component loading system, comprising: a loading device configured to pick up respective components based on a preset program; a conveying device provided with a plurality of first trays for receiving the components, and configured so that the plurality of first trays each is circularly moved between a loading position and an unloading position to allow the loading device to load the picked components on the first tray at the loading position; and a position correcting device configured to drive the conveying device or each first tray to move in a case where the first tray deviates from its loading position, so as to position the first trays at the respective loading positions thereof.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

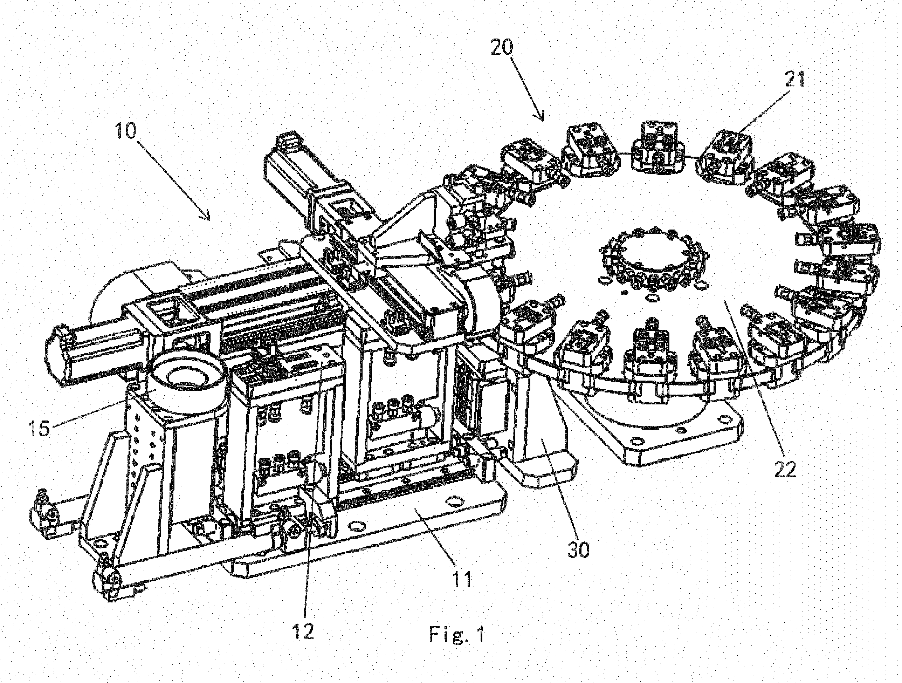

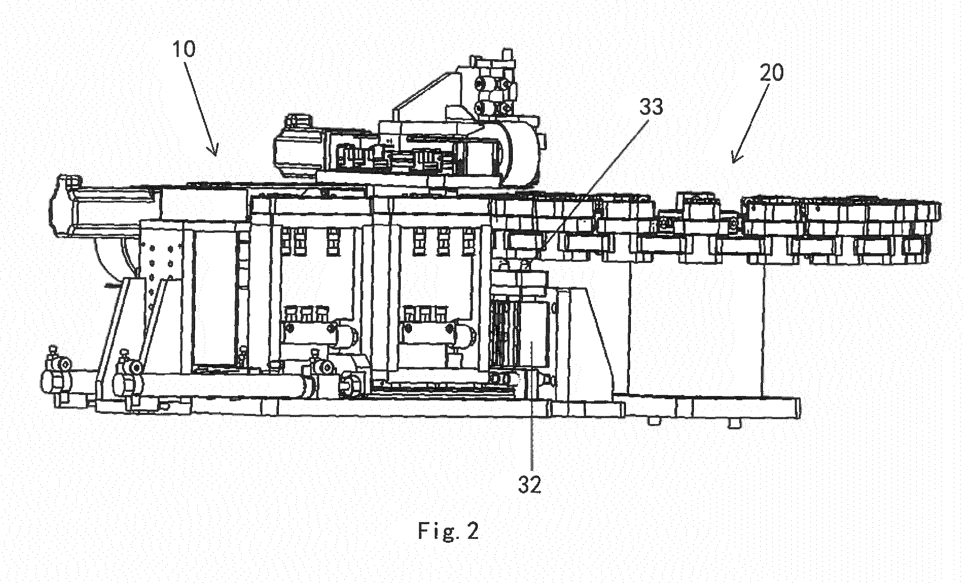

Fig.1 is an illustrative perspective view of an automatic component loading system according to an exemplary embodiment of the present invention; Fig.2 is a side view of the automatic component loading system of Fig. 1 .

As shown in Figs.1 and 2, an automatic component loading system, disclosed in an exemplary embodiment of the present invention, mainly comprises a loading device 10, a conveying device 20 and a position correcting device 30. The loading device 10 is configured to pick up respective components (not shown), such as, housing, contact, spring, bolt, insulation member or the like, based on a preset program. The conveying device 20 is provided with a plurality of first trays 21 for receiving the components. The conveying device is configured so that the plurality of first trays 21 each is circularly moved between a loading position and an unloading position to allow the loading device 10 load the picked components on the first tray 21 at the loading position, and a robot or the like may grip the components from the first tray 21 at the unloading position based on a preset program, so that the gripped components may be assembled into an electrical equipment, such as, electrical connector, fiber optic connector, relay or the like, on an operation stage by the robot in subsequent operation steps. The position correcting device 30 is configured to drive the conveying device 20 to move in a case where each first trays 21 deviates from its loading position, so as to accurately position the first tray 21 at the respective loading position thereof.

The automatic component loading system according to the embodiments of the present invention may be used to assembly other products having many tiny components simply by updating the control program. Therefore, the automatic component loading system of the present invention has a wide universality.

In an exemplary embodiment of the present invention, as shown in Figs. 1-3, the conveying device 20 comprises a turntable 22 that is rotatable in a horizontal plane. The plurality of first trays 21 are arranged on peripheral edge of the turntable 22 by a regular interval. The conveying device 20 further comprises a first base 23 and a motor 24 mounted on the first base 23. The motor 24 is configured to drive the turntable 22 to rotate. In this way, when the turntable 22 is rotated by the motor 24, the plurality of first trays 21 each is circularly moved between a loading position and an unloading position.

In an automatic component loading system according to an embodiment of the present invention, the position correcting device 30 comprises a plurality of first correcting mechanisms mounted on a lower portion of the turntable 22 and corresponding to the loading positions of the respective first trays 21; and a second correcting mechanism fixedly provided relative to the turntable 22. In a case where each first tray 21 deviates from its loading position, the second correcting mechanism drives the turntable 22 or the first tray 21 to move by cooperating with one corresponding first correction mechanisms, so as to position the first tray at the respective loading positions thereof.

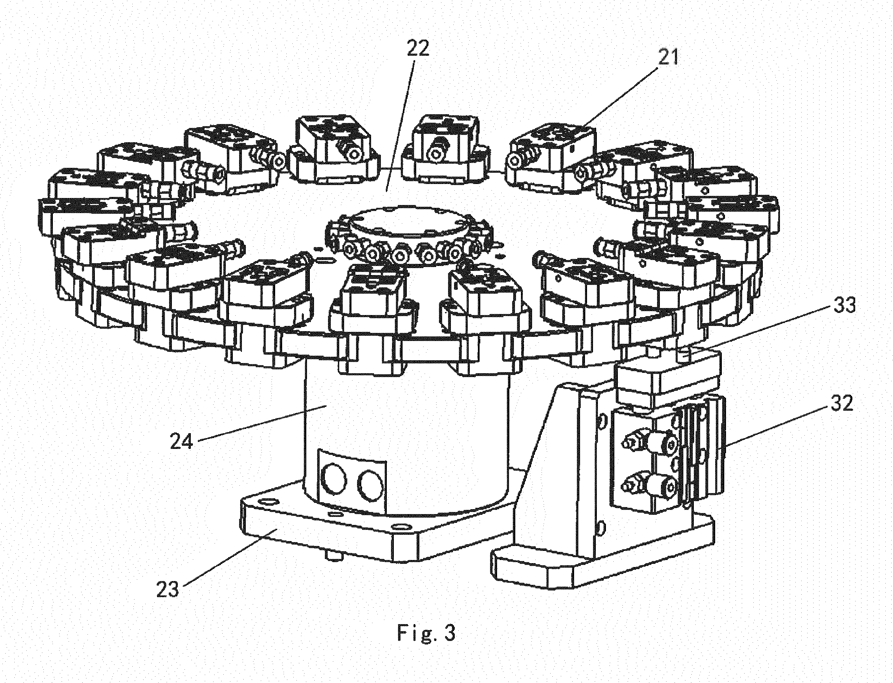

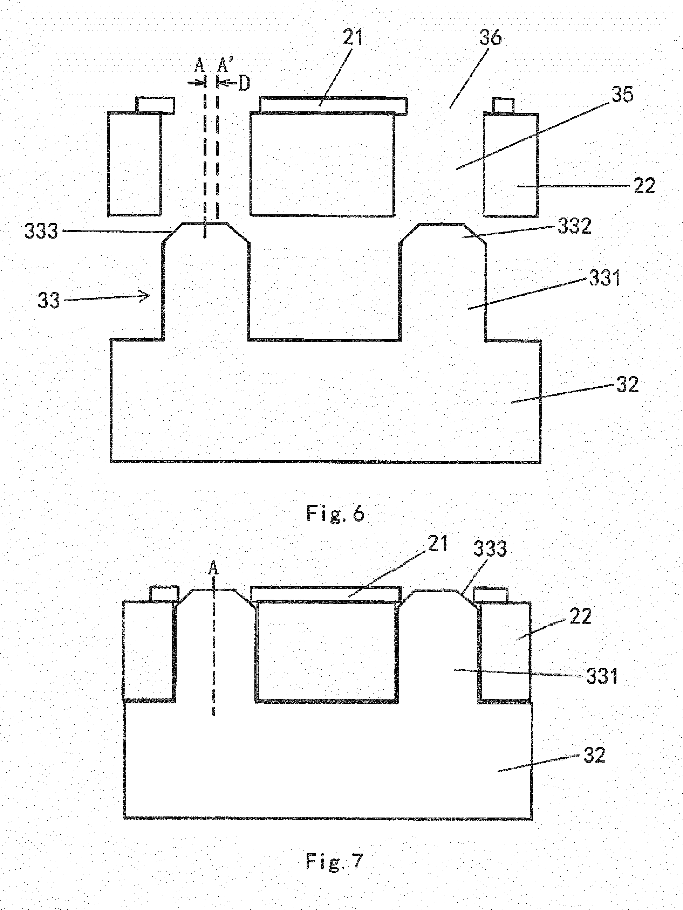

As shown in Figs.3, 6 and 7, in an embodiment, during the components on the first tray 21 are taken away by, for example, a robot, at the unloading position and/or during the empty first tray 21 is returned to the loading position, the position of the first tray 21 may be deviated relative to the turntable 22. As a result, for example, as shown in Fig.6, the first tray 21 returned to the loading position is not accurately located at its ideal loading position A, but at an actual position A' deviated from its ideal loading position A by a deviation distance D.

As for the case shown in Fig.6, in a position correcting device according to a first exemplary embodiment of the present invention, the first correcting mechanisms each comprises at least one first slot 35 passing through the turntable 22 and at least one second slot 36 extending upwardly from a bottom surface of the first tray 21 and corresponding to the respective first slot 35. The second correcting mechanism comprises at least one pin 33 and a driving device 32. The at least one pin 33 each is configured to be mated with the respective second slot 36. At least one of the pin 33 and the second slot 36 mated with each other has a sloped contact surface 333. The driving device 32 is configured to drive the at least one pin 33 into the respective second slot 36, so as to drive the first tray 21 to move by means of the contact surface 333 in the case where the first trays 21 each deviates from its loading position.

In an exemplary embodiment of the present invention, the position correcting device 30 comprises a position sensor (not shown) configured to detect a deviation of the first tray 21 from its loading position. If the deviation of the first tray 21 from its loading position detected by the position sensor goes beyond a predetermined range, the driving device 32 is activated to drive the at least one pin 33 into the respective second slot 36 through the respective first slot 35.

In an embodiment, as shown in Figs.6 and 7, the first slot 35 substantially exhibits a cylindrical shape or a truncated cone shape, and the second slot 36 substantially exhibits a cylindrical shape. The pin 33 comprises a cylindrical portion 331 mated with the second slot 35 and a cone shape or truncated cone portion 332 located at one end of the cylindrical part 331 and mated with the first slot 36. The above mentioned contact surface is formed on the truncated cone portion 332.

In an embodiment, for example, if the turntable 22 is provided with eighteen first trays 21 thereon, then one of the eighteen first trays 21 is moved to its loading position every time when the turntable is rotated by 20 degrees. At this time, the driving device 32 is automatically activated, so as to drive the pin 33 to insert into the respective first slot 35. As shown in Fig.6, if the first tray 21 on the turntable 22 is located at a position A' deviated from its ideal loading position A, the sloped contact surface 333 of the truncated cone portion 332 comes into contact with an edge of the second slot 36 during inserting the pin 33, so as to drive the first tray to its ideal loading position A, as shown in Fig.7. After the first tray 21 is moved to its ideal loading position A, the loading device 10 may accurately place the components on the first tray 21.

In the above described embodiment, two first slots 35, two second slots 36 and two pins 33 are provided. But the present invention is not limited to this, for example, one, three or more slots and pins may be provided. If two or more first and second slots are provided, these first and second slots may be arranged in a radial direction of the turntable 22 and the first tray 21 or in a circumferential direction of the turntable 22 and the first tray 21. It should be appreciated that the deviation of the first tray relative to the turntable 22 in the circumferential direction and the deviation of the first tray in the radial direction both may be corrected by mating the pin with the second slot. In an exemplary embodiment of the present invention, the position correcting device 30 drives the first tray 21 to move within a range less than 0.01mm. That is, as long as the deviation of the first tray 21 from its ideal loading position is less than 0.01 mm, it may be corrected by the position correcting device 30.

The position correcting device shown in Figs.6 and 7 may be constructed to correct the position of the first tray 21 as described above when the first tray 21 is deviated relative to the turntable 22. It should be appreciated that the position correcting device may correct the positions of the turntable 22 and the first tray 21 at the same time when the turntable 22 and the first tray 21 both are deviated from ideal positions thereof.

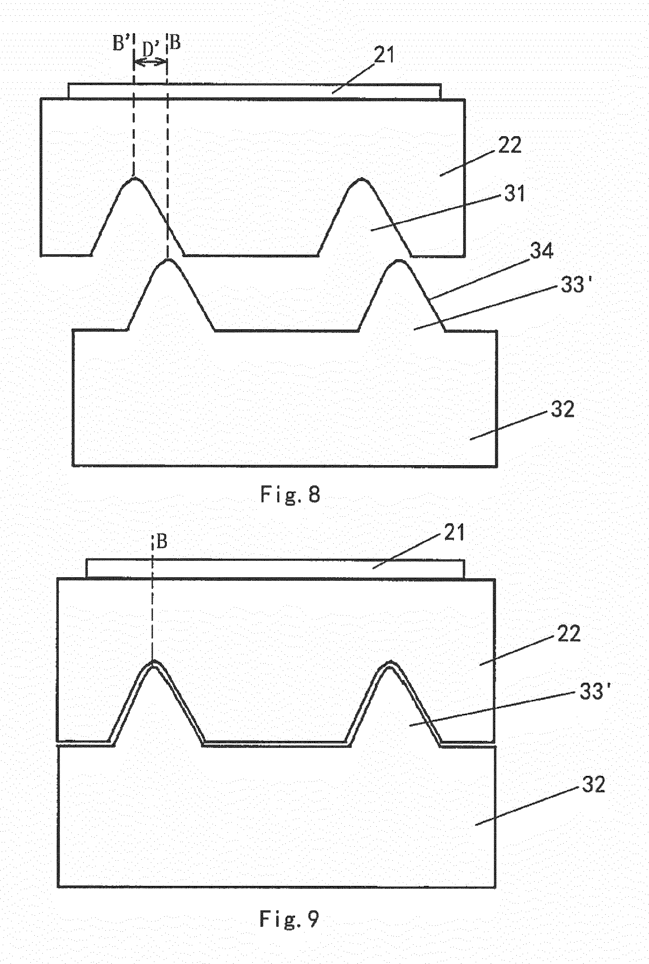

In another embodiment, as shown in Figs.8 and 9, the first correcting mechanisms each comprises two slots 31 extending upwardly from a bottom surface of the turntable 21. Correspondingly, the second correcting mechanism comprises two pins 33' and a driving device 32. The two pins 33' each is configured to be mated with the respective slot 31. At least one of the pin 33' and the slot 31 mated with each other has a sloped contact surface 34. The driving device 32 is configured to drive two pins 33' into the respective slot 31, so as to drive the turntable 22 to rotate by means of the contact surface 34 in a case where each first trays 21 deviates from its ideal loading position A.

In an embodiment, for example, if the turntable 22 is provided with eighteen first trays 21 thereon, then one of the eighteen first trays 21 is moved to its loading position every time when the turntable 22 is rotated by 20 degrees. At this time, the driving device 32 is automatically activated, so as to drive the pin 33' to insert into the respective first slot 31. As shown in Fig.8, in a case where the first tray 21 is fixed relative to the turntable 22 and where the turntable 22 is deviated, if the first tray 21 on the turntable 22 is located at a position B' deviated from its ideal loading position B, the sloped contact surface 34 of the pin 33' comes into contact with an edge of the slot 31 during inserting the pin 33' into the slot 31, so as to drive the turntable 22 to rotate, and move the first tray 21 to its ideal loading position B, as shown in Fig.9. After the first tray 21 is moved to its ideal loading position B, the loading device 10 may accurately place the components on the first tray 21.

In the above described embodiment, two slots 31 and two pins 33' are provided. But the present invention is not limited to this, for example, one, three or more slots and pins may be provided. If two or more slots are provided, these slots may be arranged in a radial direction of the turntable 22 or in a circumferential direction of the turntable 22. It should be appreciated that the deviations of the first tray in the circumferential direction and in the radial direction both may be corrected by mating the pin with the slot. In an exemplary embodiment of the present invention, the position correcting device 30 drives the turntable 22 to rotate, so as to move the first tray 21 within a range less than 0.01mm. That is, as long as the deviation of the first tray 21 from its ideal loading position is less than 0.01 mm, it may be corrected by the position correcting device 30.

In an exemplary embodiment of the present invention, the driving device 32 may comprise motor, electromagnetic clutch mechanism, or pneumatic drive device, but the present invention is not limited to this, the driving device 32 may be any suitable device as long as it may insert the pin into the slot.

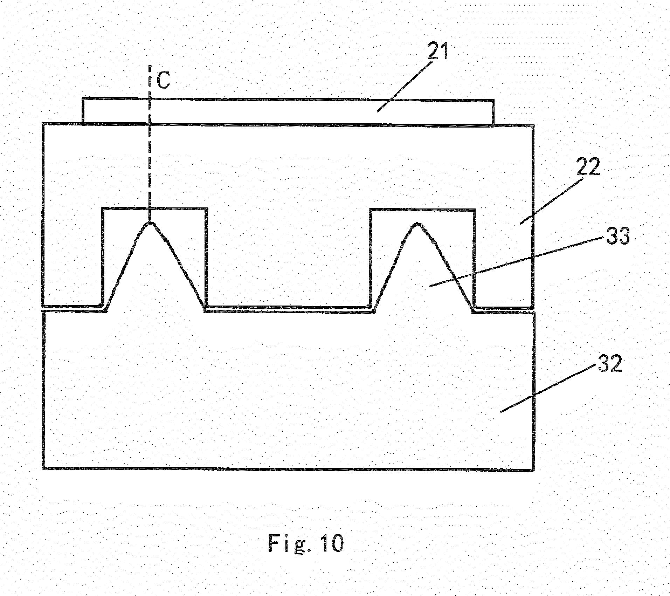

In an exemplary embodiment shown in Figs.8 and 9, the slot 31 and the pin 33' both substantially exhibit a cone shape. In an alternative embodiment, as shown in Fig.10, the slot substantially exhibits a cylindrical shape, and the pin 33 substantially exhibits a cone shape. With the configuration shown in Fig.10, when the turntable 22 is stopped at the loading position, if the first tray 21 on the turntable 22 is deviated from its ideal loading position C, the sloped contact surface of the pin 33 becomes into contact with an edge of the slot during inserting the pin 33 into the slot, so as to drive the turntable 22 to rotate, and move the first tray 21 to its ideal loading position C.

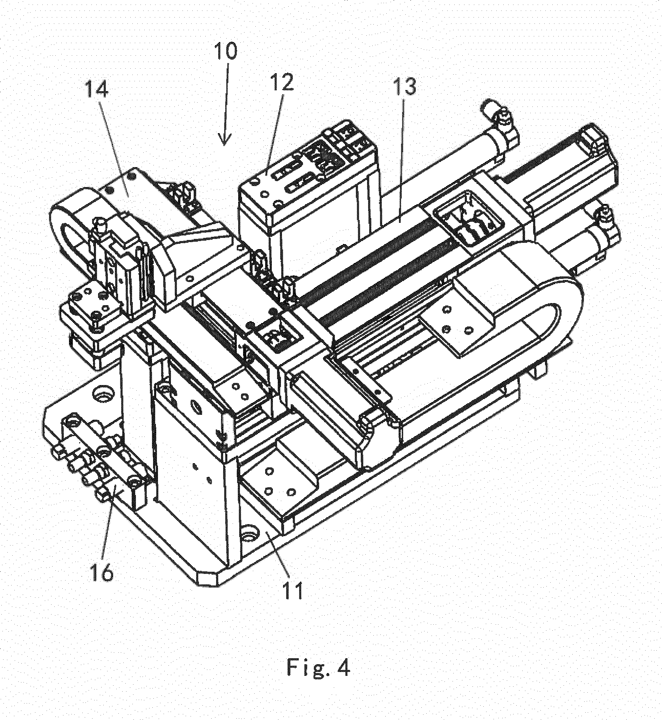

In an automatic component loading system according to an exemplary embodiment of the present invention, as shown in Fig.4, the loading device 10 comprises a second base 11, a second tray 12, a reciprocating device 13 and a picking device 14. The second tray 12, on which the components are pre-placed, is mounted on the second base11. The reciprocating device 13 is mounted on the second base 11. The picking device 14 is movably mounted on the reciprocating device 13 and configured to pick up the components from the second tray 12 and place the picked components on the respective first trays 21 which is positioned at the ideal loading position thereof. In this way, by reciprocating the picking device 14 on the reciprocating device 13, the components may be transferred from the second tray 12 to the first tray 21.

In an embodiment, the second correcting mechanism is fixed to the loading device 10. More specifically, the second correcting mechanism is fixed to the second base 11 of the loading device 10. For example, as shown in Fig.4, the second correcting mechanism is fixed to the second base 11 by screwing bolts 16 provided on the second base 11 into thread holes (not shown) formed in the second correcting mechanism. In this way, it may hold the second correcting mechanism of the position correcting device in a fixed state relative to the turntable 22. The reciprocating device 13 is constructed to bring the picking device to reciprocate under the control of a controlling device (not shown). The reciprocating device 13 may comprise any one of rail moving device, belt transmitting device and roll transmitting device.

In an exemplary embodiment, as shown in Fig.1, the loading device 10 further comprises a storage device 15 for storing the components. The automatic component loading system further comprises a first robot configured to transfer the components from the storage device 15 to the second tray 12.

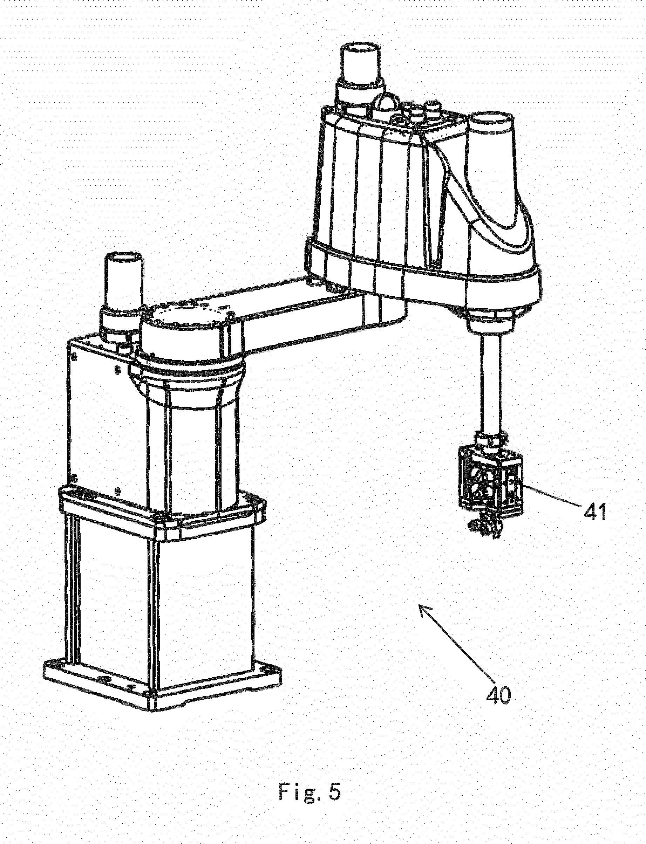

As shown in Fig.5, in an exemplary embodiment of the present invention, the automatic component loading system further comprises a second robot 40 configured to pick up the respective components from the first tray 21 at the unloading position based on a preset program. The second robot 40 comprises a plurality of grippers 41 configured to pick up various components with different shapes. The first robot and the second robot may comprise but not limited to four-axis robot, six-axis robot or any other suitable multi-freedom robot. These robots may control the grippers 41 to grip respective components based on preset program.

For example, the gripper 41 comprises a large sucker configured to grip a conductive terminal, a small sucker configured to grip a wire, and a plurality of arms configured to a large component, for example, a housing of a connector. There may be provided one or more different types of grippers mounted on the robot as necessary.

Although the conveying device is described as the turntable in the above embodiments, the present invention is not limited to this. In an alternative embodiment, the conveying device may comprise any suitable linear conveying device, such as, belt conveyor, chain conveyor, etc..

As described above, in a case where the first tray 21 and/or the turntable deviates from the ideal loading position A thereof, it may use the position correcting device described in the first embodiment to correct the position of the first tray 21 and/or the turntable. In the first embodiment, by driving the movable pin 33 into the second slot 36 of the first tray 21, the first tray 21 and/or the turntable is driven to move, and the first tray 21 is moved to its ideal loading position. In a case where the turntable deviates from the ideal loading position A thereof, it may use the position correcting device described in the second or third embodiment to correct the position of the turntable. In the second or third embodiment, by driving the movable pin 33' into the slot 31 of the turntable 22, the turntable 22 is driven to move, and then the first tray 21 is driven by the turntable 22 and moved to its ideal loading position.

In the automatic component loading system according to various embodiments of the present invention, the position correcting device is provided. The position correcting device drives the conveying device to move in the case where the first trays each deviates from its loading position, so that the first tray and/or the turntable is moved to position the first tray at its ideal loading position. Thereby, it may repeatedly position the first tray and/or the turntable, so that operations of loading and unloading the components are repeated in consistence, ensuring that the first tray, on which the components to be loaded, is accurately and efficiently positioned at its ideal loading position. In this way, the components may be loaded on respective locations on the first tray, facilitating a subsequent operation of automatically gripping the components, and improving the quality and efficiency of manufacturing/assembling the electrical equipment. During the position correction, repeatedly positioning of the first tray or the turntable may be achieved without using a position control device, such as, a position sensor, a controller and the like, , decreasing the cost of the electrical equipment, and reducing the cycle operation time of loading and unloading the components. The automatic component loading system according to embodiments of the present invention may be served as an intermediate module for loading and unloading the components in high precision during manufacturing the electronic equipment.

It should be appreciated for those skilled in this art that the above embodiments are intended to be illustrated, and not restrictive.

Although several exemplary embodiments have been shown and described, it would be appreciated by those skilled in the art that various changes or modifications may be made in these embodiments without departing from the principles of the disclosure, the scope of which is defined in the claims and their equivalents.

## Claims

1. An automatic component loading system, comprising:
a loading device (10) configured to pick up respective components based on a preset program;
a conveying device (20) provided with a plurality of first trays (21) for receiving the components thereon and configured so that the plurality of first trays (21) each is moved between a loading position and an unloading position to allow the loading device to load the picked components on the first tray (21) at the loading position; wherein the conveying device (20) comprises a turntable (22) constructed to rotate in a horizontal plane, the plurality of first trays (21) being arranged on the peripheral edge of the turntable (22) by a regular interval, or a linear conveying device such as a belt conveyor or a chain conveyor, and said automatic component loading system being **characterized in that** it further comprises
a position correcting device (30) configured to drive the conveying device (20) or each first tray (21) to move in a case where the first tray deviates from its loading position, so as to position the first trays (21) at the respective loading positions thereof, wherein the position correcting device comprises:
a plurality of first correcting mechanisms mounted on a lower portion of the turntable (22) or the linear conveying device, and corresponding to the loading positions of the respective first trays (21); and
a second correcting mechanism fixedly provided relative to the turntable (22) or the linear conveying device,
wherein the second correcting mechanism is configured to drive the turntable (22) or the linear conveying device or the first trays (21) to move, by cooperating with each first correction mechanisms, in the case where each first tray (21) deviates from its loading position A, B, C, so as to position the first trays (21) at the respective loading positions A, B, C thereof, wherein the first correcting mechanisms each comprises:
at least one first slot (35) passing through the turntable (22) or the linear conveying device; and
at least one second slot (36) extending upwardly from a bottom surface of the first (21) tray and corresponding to the respective first slot (35), and
the second correcting mechanism comprising:
a t least one pin (33, 33') each configured to be mated with the respective slot (35, 36), at least one of the pin (33, 33') and the slot (35, 36) mated with each other having a sloped contact surface (34, 333); and
a driving device (32) configured to drive the at least one pin (33, 33') into the respective slot (35, 36), so as to drive the first tray (21) to move by means of the contact surface (34) in the case where each first tray (21) deviates from its loading position A, B, C.

2. The automatic component loading system according to claim 1, wherein the slot (35, 36) and the pin (33, 33') both substantially exhibit a cone shape.

3. The automatic component loading system according to one of claims 1 to 2, wherein the slot (35, 36) substantially exhibits a cylindrical shape, and the pin (33, 33') substantially exhibits a cone shape.

4. The automatic component loading system according to one of claims 1 to 3, wherein the second slot (36) substantially exhibits a cylindrical shape or a truncated cone shape, and the first slot (35) substantially exhibits a cylindrical shape, and
wherein the pin (33, 33') comprising:
a cylindrical portion (331) mated with the first slot (35); and
a truncated cone portion (332) located at one end of the cylindrical portion (331) and mated with the second slot (36), the contact surface being formed on the truncated cone portion (332).

5. The automatic component loading system according to one of claims 1 to 4, wherein the position correcting device (30) drives the turntable (22) or the linear conveying device to rotate, so as to move the first tray (21) within a range less than 0.01 mm.

6. The automatic component loading system according one of claims 1 to 5, wherein the second correcting mechanism is fixed on the loading device 10.

7. The automatic component loading system according to one of claims 1 to 6, wherein the position correcting device (30) comprises a position sensor configured to detect a deviation of the first tray (21) from its loading position A, B, C.

8. The automatic component loading system according to one of claims 1 to 7, wherein the conveying device (20) further comprising:
a first base (23); and
a motor (24) mounted on the first base (23) and configured to drive the turntable (22) or the linear conveying device to rotate.

9. The automatic component loading system according to any of claims 1 to 8, wherein the loading device comprising:
a second base (11);
a second tray (12), on which the components are pre-placed, mounted on the second base (11);
a rail mounted on the second base (11); and
a picking device (14) movably mounted on the rail and configured to pick up the components from the second tray (12) and place the picked components on the respective first trays (21).

10. The automatic component loading system according to claim 9, wherein the loading device (10) further comprises a storage device (15) for storing the components and/or further comprising a first robot configured to transfer the components from the storage device (15) to the second tray (12).

11. The automatic component loading system according to any of claims 1 to 10, further comprising a second robot (40) configured to pick up the respective components from the first tray (21) at the unloading position based on a preset program.

## Patentansprüche

1. System zum automatischen Laden von Bauteilen, umfassend:
eine Ladevorrichtung (10), die konfiguriert ist zum Aufgreifen von entsprechenden Bauteilen basierend auf einem voreingestellten Programm,
eine Transporteinrichtung (20), die mit einer Vielzahl von ersten Schalen (21) für das Aufnehmen der Bauteile versehen ist und derart konfiguriert ist, dass die Vielzahl von ersten Schalen (21) jeweils zwischen einer Ladeposition und einer Entladeposition bewegt werden, damit die Ladevorrichtung die aufgegriffenen Bauteile an der Ladeposition auf die erste Schale (21) laden kann, wobei die Transporteinrichtung (20) eine Drehscheibe (22), die für eine Drehung in einer horizontalen Ebene ausgebildet ist, wobei die Vielzahl von ersten Schalen (21) an dem Umfangsrand der Drehscheibe (22) mit einem regelmäßigen Intervall angeordnet sind, oder eine lineare Transporteinrichtung wie etwa ein Bandförderer oder ein Kettenförderer ist,
wobei das System zum automatischen Laden von Bauteilen weiterhin umfasst:
eine Positionskorrektureinrichtung (30), die konfiguriert ist zum Antreiben der Transporteinrichtung (20) oder jeder ersten Schale (21) für eine Bewegung, wenn die erste Schale von ihrer Ladeposition abweicht, um die ersten Schalen (21) an den entsprechenden Ladepositionen zu positionieren, wobei die Positionskorrektureinrichtung umfasst:
eine Vielzahl von ersten Korrekturmechanismen, die an einem unteren Teil der Drehscheibe (22) oder der linearen Transporteinrichtung montiert sind und den Ladepositionen der entsprechenden ersten Schalen (21) entsprechen, und
einen zweiten Korrekturmechanismus, der fix relativ zu der Drehscheibe (22) oder der linearen Transporteinrichtung vorgesehen ist,
wobei der zweite Korrekturmechanismus konfiguriert ist zum Antreiben der Drehscheibe (22) oder der linearen Transporteinrichtung oder der ersten Schalen (21) für eine Bewegung durch das Zusammenwirken mit jeweils den ersten Korrekturmechanismen, wenn die ersten Schalen (21) von ihren Ladepositionen A, B, C abweichen, um die ersten Schalen (21) an den entsprechenden Ladepositionen A, B, C zu positionieren,
wobei jeder erste Korrekturmechanismus umfasst:
wenigstens einen ersten Schlitz (35), der sich durch die Drehscheibe (22) oder die lineare Transporteinrichtung erstreckt, und
wenigstens einen zweiten Schlitz (36), der sich von einer Bodenfläche der ersten Schale (21) nach oben erstreckt und dem entsprechenden ersten Schlitz (35) entspricht,
und der zweite Korrekturmechanismus umfasst:
wenigstens einen Stift (33, 33'), der konfiguriert ist, um mit dem entsprechenden Schlitz (35, 36) verbunden zu werden, wobei der wenigstens eine Stift (33, 33') und der damit verbundene Schlitz (35, 36) eine schräge Kontaktfläche (34, 333) aufweisen, und
eine Antriebseinrichtung (32), die konfiguriert ist zum Antreiben des wenigstens einen Stifts (33, 33') in den entsprechenden Schlitz (35, 36), um die erste Schale (21) für eine Bewegung mittels der Kontaktfläche (34) anzutreiben, wenn die erste Schale (21) von ihrer Ladeposition A, B, C abweicht.

2. System zum automatischen Laden von Bauteilen nach Anspruch 1, wobei der Schlitz (35, 36) und der Stift (33, 33') beide im Wesentlichen eine Kegelform aufweisen.

3. System zum automatischen Laden von Bauteilen nach Anspruch 1 oder 2, wobei der Schlitz (35, 36) im Wesentlichen eine zylindrische Form aufweist und der Stift (33, 33') im Wesentlichen eine Kegelform aufweist.

4. System zum automatischen Laden von Bauteilen nach einem der Ansprüche 1 bis 3, wobei:
der zweite Schlitz (36) im Wesentlichen eine zylindrische Form oder eine Kegelstumpfform aufweist und wobei der erste Schlitz (35) im Wesentlichen eine zylindrische Form aufweist, und
wobei der Stift (33, 33') umfasst:
einen zylindrischen Teil (331), der mit dem ersten Schlitz (35) verbunden ist, und
einen Kegelstumpfteil (332), der an einem Ende des zylindrischen Teils (331) angeordnet ist und mit dem zweiten Schlitz (36) verbunden ist, wobei die Kontaktfläche an dem Kegelstumpfteil (332) ausgebildet ist.

5. System zum automatischen Laden von Bauteilen nach einem der Ansprüche 1 bis 4, wobei die Positionskorrektureinrichtung (30) die Drehscheibe (22) oder die lineare Transporteinrichtung für eine Drehung antreibt, um die erste Schale (21) innerhalb eines Bereichs von weniger als 0,01 mm zu bewegen.

6. System zum automatischen Laden von Bauteilen nach einem der Ansprüche 1 bis 5, wobei der zweite Korrekturmechanismus an der Ladeeinrichtung 10 fixiert ist.

7. System zum automatischen Laden von Bauteilen nach einem der Ansprüche 1 bis 6, wobei die Positionskorrektureinrichtung (30) einen Positionssensor umfasst, der konfiguriert ist zum Erfassen einer Abweichung der ersten Schale (21) von ihrer Ladeposition A, B, C.

8. System zum automatischen Laden von Bauteilen nach einem der Ansprüche 1 bis 7, wobei die Transporteinrichtung (20) weiterhin umfasst:
eine erste Basis (23), und
einen Motor (24), der an der ersten Basis (23) montiert ist und konfiguriert ist zum Antreiben der Drehscheibe (22) oder der linearen Transporteinrichtung für eine Drehung.

9. System zum automatischen Laden von Bauteilen nach einem der Ansprüche 1 bis 8, wobei die Ladeeinrichtung umfasst:
eine zweite Basis (11),
eine zweite Schale (12), an der die Bauteile vorplatziert werden und die an der zweiten Basis (11) montiert ist,
eine Schiene, die an der zweiten Basis (11) montiert ist, und
eine Aufgreifeinrichtung (14), die beweglich an der Schiene montiert ist und konfiguriert ist zum Aufgreifen der Bauteile von der zweiten Schale (12) und zum Platzieren der aufgegriffenen Bauteile an den entsprechenden ersten Schalen (21).

10. System zum automatischen Laden von Bauteilen nach Anspruch 9, wobei die Ladeeinrichtung (10) weiterhin eine Speichereinrichtung (15) zum Speichern der Bauteile aufweist und/oder weiterhin einen ersten Roboter umfasst, der konfiguriert ist zum Übertragen der Bauteile von der Speichereinrichtung (15) zu der zweiten Schale (12).

11. System zum automatischen Laden von Bauteilen nach einem der Ansprüche 1 bis 10, das weiterhin einen zweiten Roboter (40) umfasst, der konfiguriert ist zum Aufgreifen der entsprechenden Bauteile von der ersten Schale (21) an der Entladeposition basierend auf einem voreingestellten Programm.

## Revendications

1. Système automatique de chargement de composants, comprenant :
un dispositif de chargement (10) configuré pour saisir des composants respectifs selon un programme prédéfini ;
un dispositif de convoyage (20) doté d'une pluralité de premiers plateaux (21) pour recevoir les composants sur ceux-ci et configuré de sorte que de la pluralité de premiers plateaux (21) chacun est déplacé entre une position de chargement et une position de déchargement pour permettre au dispositif de chargement de charger les composants saisis sur le premier plateau (21) sur la position de chargement ;
dans lequel le dispositif de convoyage (20) comprend une plaque tournante (22) constituée pour tourner dans un plan horizontal, la pluralité de premiers plateaux (21) étant disposée sur l'arête périphérique de la plaque tournante (22) selon un intervalle régulier, ou un dispositif de convoyage linéaire tel qu'un convoyeur à courroie ou à chaîne, et ledit système automatique de chargement de composants étant **caractérisé en ce qu'**il comprend en outre
un dispositif de correction de position (30) configuré pour entraîner le dispositif de convoyage (20) ou chaque premier plateau (21) en déplacement dans un cas où le premier plateau dévie de sa position de chargement, de sorte à positionner les premiers plateaux (21) sur les positions de chargement respectives de ceux-ci, dans lequel le dispositif de correction de position comprend :
une pluralité de premiers mécanismes de correction montés sur une partie inférieure de la plaque tournante (22) ou le dispositif de convoyage linéaire, et correspondant aux positions de chargement des premiers plateaux respectifs (21) ; et
un deuxième mécanisme de correction installé de manière fixe par rapport à la plaque tournante (22) ou au dispositif de convoyage linéaire,
dans lequel le deuxième mécanisme de correction est configuré pour entraîner la plaque tournante (22) ou le dispositif de convoyage linéaire ou les premiers plateaux (21) en déplacement, en coopérant avec chacun des premiers mécanismes de correction, dans le cas où chaque premier plateau (21) dévie de sa position de chargement A, B, C, de sorte à positionner les premiers plateaux (21) sur des positions de chargement respectives A, B, C de ceux-ci, dans lequel les premiers mécanismes de correction comprennent chacun :
au moins un premier logement (35) traversant la plaque tournante (22) ou le dispositif de convoyage linéaire ; et
au moins un deuxième logement (36) s'étendant vers le haut depuis une surface de fond du premier plateau (21) et correspondant au premier logement respectif (35), et
le deuxième mécanisme de correction comprenant :
au moins une tige (33, 33') chacune configurée pour être couplée au logement respectif (35, 36), au moins une de la tige (33, 33') et du logement (35, 36) couplés l'un avec l'autre présentant une surface de contact inclinée (34, 333) ; et
un dispositif d'entraînement (32) configuré pour entraîner l'au moins une tige (33, 33') dans le logement respectif (35, 36), de sorte à entraîner le premier plateau (21) pour en déplacement au moyen de la surface de contact (34) dans le cas où chaque premier plateau (21) dévie de sa position de chargement A, B, C.

2. Le système automatique de chargement de composants selon la revendication 1, dans lequel le logement (35, 36) et la tige (33, 33') présentent tous deux substantiellement une forme conique.

3. Le système automatique de chargement de composants selon l'une des revendications 1 à 2, dans lequel le logement (35, 36) présente substantiellement une forme cylindrique, et la tige (33, 33') présente substantiellement une forme conique.

4. Le système automatique de chargement de composants selon l'une des revendications 1 à 3,
dans lequel le deuxième logement (36) présente substantiellement une forme cylindrique ou une forme de cône tronqué, et le premier logement (35) présente substantiellement une forme cylindrique, et
dans lequel la tige (33, 33') comprend :
une partie cylindrique (331) couplée au premier logement (35) ; et
une partie de cône tronqué (332) située à une extrémité de la partie cylindrique (331) et couplée au deuxième logement (36), la surface de contact étant constituée sur la partie de cône tronqué (332).

5. Le système automatique de chargement de composants selon l'une des revendications 1 à 4,
dans lequel le dispositif de correction de position (30) entraîne en rotation la plaque tournante (22) ou le dispositif de convoyage linéaire, de sorte à déplacer le premier plateau (21) au sein d'une plage inférieure à 0,01 mm.

6. Le système automatique de chargement de composants selon l'une des revendications 1 à 5, dans lequel le deuxième mécanisme de correction est fixé sur le dispositif de chargement (10).

7. Le système automatique de chargement de composants selon l'une des revendications 1 à 6, dans lequel le dispositif de correction de position (30) comprend un capteur de position configuré pour détecter un écart du premier plateau (21) de sa position de chargement A, B, C.

8. Le système automatique de chargement de composants selon l'une des revendications 1 à 7, dans lequel le dispositif de convoyage (20) comprend en outre :
une première base (23) ; et
un moteur (24) monté sur la première base (23) et configuré pour entraîner en rotation la plaque tournante (22) ou le dispositif de convoyage linéaire.

9. Le système automatique de chargement de composants selon l'une des revendications 1 à 8, dans lequel le dispositif de chargement comprend :
une deuxième base (11) ;
un deuxième plateau (12), sur lequel les composants sont pré-positionnés, monté sur la deuxième base (11) ;
un rail monté sur la deuxième base (11) ; et
un dispositif de saisie (14) monté de manière mobile sur le rail et configuré pour saisir les composants sur le deuxième plateau (12) et placer les composants saisis sur les premiers plateaux respectifs (21).

10. Le système automatique de chargement de composants selon la revendication 9, dans lequel le dispositif de chargement (10) comprend en outre un dispositif de stockage (15) pour stocker les composants et/ou comprenant en outre un premier robot configuré pour transférer les composant du dispositif de stockage (15) au deuxième plateau (12).

11. Le système automatique de chargement de composants selon l'une quelconque des revendications 1 à 10, comprenant en outre un deuxième robot (40) configuré pour saisir les composants respectifs sur le premier plateau (21) sur la position de déchargement selon un programme prédéfini.
